# EUROPEAN PATENT APPLICATION

(11) **EP 2 624 311 A1**
(43) Date of publication of application: **07.08.2013**
(21) Application number: 11829048.5
(22) Date of filing: 26.09.2011
(51) Int. Cl.: H01L 31/042

(54) **SOLAR CELL MODULE AND METHOD FOR PRODUCING SOLAR CELL MODULE**

(30) Priority: 29.09.2010 JP 2010219384
(71) Applicant: Dexerials Corporation, Tokyo 141-0032 (JP)
(72) Inventor: OKUMIYA, Hideaki, Shinagawa, Tokyo (JP); SUGA, Yasuhiro, Shinagawa, Tokyo (JP); HIGUCHI, Akifumi, Shinagawa, Tokyo (JP)
(74) Representative: Müller - Hoffmann & Partner
(86) International application number: PCT/JP2011/071922
(87) International publication number: WO 2012/043494

(57) **Abstract**

To ensure conductivity between a tab wire on which concave/convex portions are formed and electrodes of solar battery cells. A plurality of solar battery cells (2), each having two surfaces on which electrodes (11) and (13) are formed, a tab wire (3) that is provided with concave/convex portions (21) composed of peak portions (2 1 a) and bottom portions (21b) which continue in a longitudinal direction, and are alternately formed in a width direction on one of the surfaces, with the tab wire (3) being used for connecting the plural solar battery cells (2) in series with one after another, and an adhesive film (15) that is interposed between the electrodes (11) and (13) of the solar battery cells (2) and the tab wire (3) so as to connect the solar battery cells (2) and the tab wire (3) are installed, and in this structure, each of the solar battery cells (2) has a flow-in unit (16) in which a binder component of the adhesive film (15) is allowed to flow, which is formed on a connection unit to which the one of the surfaces with the concave/convex portions (21) formed thereon is connected.

## Description

### Field of the Invention

This invention relates to a solar battery module in which electrodes of a plurality of solar battery modules are connected to one another by a tab wire, and a method for manufacturing such a solar module.
The present application claims priority rights to JP Patent Application 2010-219384 filed in Japan on September 29, 2010, which is hereby incorporated by reference.

### Background of the Invention

In a crystal silicon-based solar battery module, a plurality of solar battery cells adjacent to each other are connected each other by a tab wire made of a ribbon-shaped copper foil, or the like, coated with solder, which serves as an interconnector. The tab wire has one of its end side connected to the surface electrodes of each of the solar battery cells, with the other end side being connected to rear-surface electrodes of the solar battery cell adjacent thereto; thus, the respective solar battery cells are connected in series with one after another.

More specifically, the connection between the solar battery cells and the tab wire is made by carrying out a soldering process between a bus bar electrode formed on a light-receiving surface of each solar battery cell by a screen printing of a silver paste, as well as an Ag electrode formed on a rear-surface connection unit of each solar battery cell, and the tab wire (Patent Literature 1). Additionally, on areas other than the connection unit on the rear-surface of the solar battery cell, an Al electrode or an Ag electrode is formed.

In this case, however, since a connection treatment at a high temperature as high as about 260°C is carried out in the soldering process, the degradation of connection reliability between the tab wires and the surface electrodes as well as the rear-surface electrodes of the solar battery cells, caused by warping of the solar battery cells, an inner stress generated in the connection unit between the tab wire and the surface electrodes, as well as the rear surface electrodes, and residual flux, etc., is worried about.

For this reason, conventionally, a conductive adhesive film capable of providing connection by a heat contact-bonding treatment at a comparatively low temperature is used for the connection between the surface electrodes of the solar battery cells, as well as the rear-surface electrodes thereof, and the tab wire (Patent Literature 2). As such a conductive adhesive film, a material, prepared by dispersing spherical or scale-shaped conductive particles having an average particle size in the order of several µms in a thermosetting binder resin composition so as to be formed into a film shape, is used.

The conductive adhesive film is interposed between the surface electrodes, as well as the rear-surface electrodes, and the tab wire, and then heated and pressed on the tab wire so that the binder resin is allowed to exert flowability to flow out between the electrodes as well as between the tab wires, with the conductive particles providing conduction between the electrodes and the tab wire, and the binder resin is thermally cured in this state. With this arrangement, strings each having a plurality of solar battery cells series-connected by the tab wire are formed.

The plural solar battery cells, each having its surface electrodes, as well as its rear-surface electrodes, connected to the tab wire by using the conductive adhesive film, are sealed between a surface protective member having transparency, such as glass, a translucent plastic material, or the like, and a rear-surface protective member made of a film such as PET (Poly Ethylene Terephthalate), by using a sealing material having transparency such as ethylene vinyl acetate (EVA).

### Prior-Art Documents

### Patent Document

PTL 1: Japanese Patent Application Laid-Open No. 2004-356349
PTL 2: Japanese Patent Application Laid-Open No. 2008-135654

### Summary of the Invention

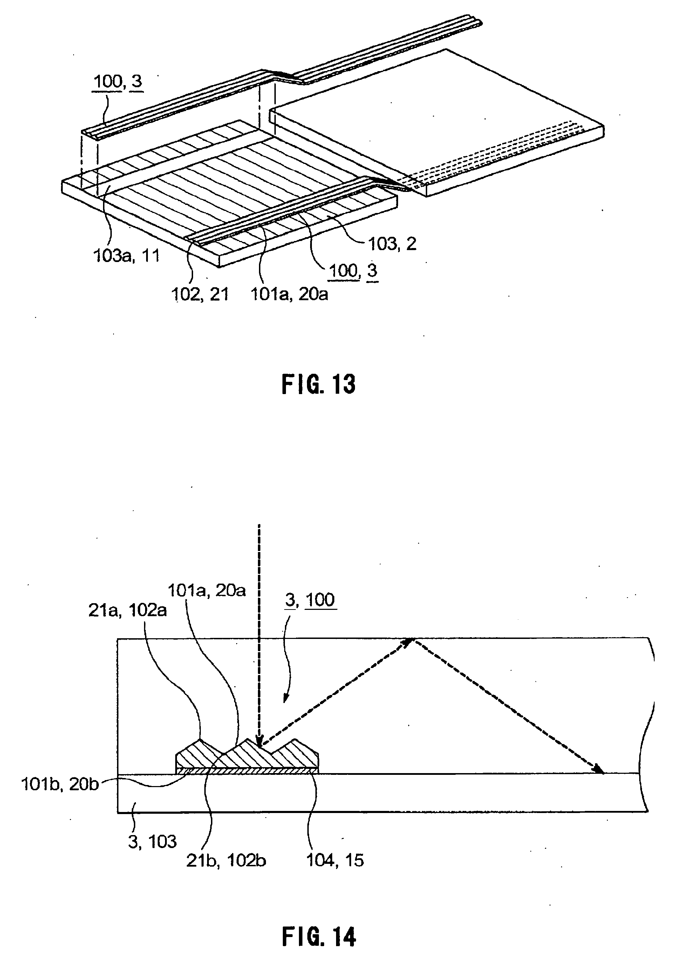

In recent years, as a tab wire for use in connecting the tab wire with the surface electrodes and the rear-surface electrodes, such a tab wire in which concave/convex portions are formed on its one surface has been proposed. As shown in Fig. 13, this tab wire 100 is formed into an elongated shape, with concave/convex portions 102 being formed on its surface 101a. As shown in Fig. 14, the concave/convex portions 102 are composed of peak portions 102a and bottom portions 102b which continue in a longitudinal direction of the tab wire 100, and are alternately formed in a width direction.

Moreover, the tab wire 100 is connected to surface electrodes 103a of the solar battery cells 103 on its rear surface 101 b side with a conductive adhesive film 104 interpolated therebetween. Thus, in each solar battery cell 103, since the concave/convex portions 102 are directed in the same direction as that of the light-receiving surface, incident light is scattereds by the concave/convex portions 102 and the scattered light rays are reflected by a protective glass surface and made re-incident on the light-receiving surface so that the light receiving efficiency can be improved.

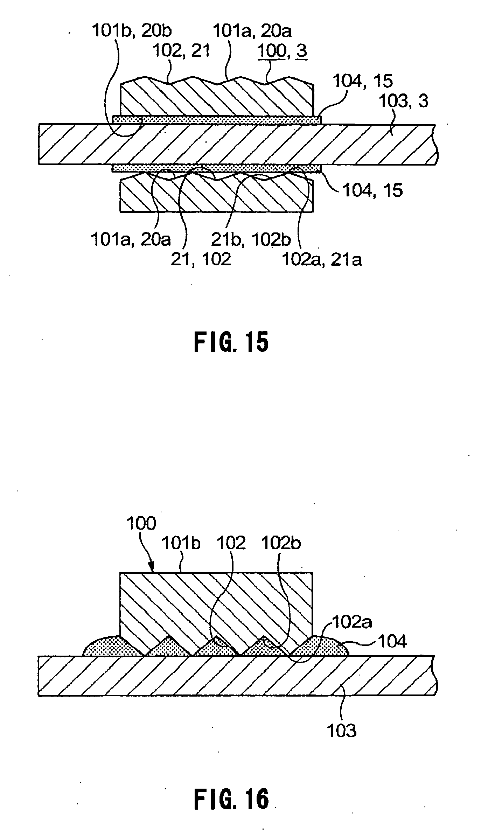

In this case, however, in the solar battery cells 103, since a surface 101a of the tab wire 100 is connected onto the rear-surface side thereof, as shown in Fig. 15, the outflow of the binder resin of the conductive adhesive film 104 is restricted by the concave/convex portions 102 of the conductive adhesive film 104 in the heating and pressing process of the tab wire 100, with the result that conductivity between the tab wire 100 and the rear-surface electrodes provided by the conductive particles might be lowered. That is, even in the case when the binder resin exerts flowability by the heating process, the conductive adhesive film 104 has its flowing direction restricted in a direction along the bottom portions 102b because the peak portions 102a and the bottom portions 102b are continuously formed along the longitudinal direction of the tab wire 100, with the result that the outflow between the peak portions 102a of the tab wire 100 and the connection unit of the rear-surface electrodes becomes insufficient even upon application of a pressure. Therefore, as shown in Fig. 16, in each of the solar battery cells 103, a large amount of binder resin remains between the tab wire 100 and the connection unit of the rear-surface electrodes, with the result that the contact between the peak portions 102a and the rear-surface electrodes and the mutual contact among the conductive particles are obstructed to cause degradation of conductivity.

Therefore, the present invention relates to a solar battery module in which solar battery cells are connected with one another by using a tab wire with concave/convex portions formed thereon, and its objective is to provide a solar battery module that can ensure conductivity and a method for manufacturing such a module.

In order to solve the above-mentioned problems, a solar battery module in accordance with the present invention is provided with: a plurality of solar battery cells, each having two surfaces on which electrodes are formed; a tab wire that is provided with concave/convex portions composed of peak portions and bottom portions which continue in a longitudinal direction, and are alternately formed in a width direction on one of the surfaces, with the tab wire being used for connecting the plural solar battery cells in series with one after another; and an adhesive film that is interposed between the electrodes of the solar battery cells and the tab wire so as to connect the solar battery cells and the tab wire, and in this structure, each of the solar battery cells has a flow-in unit in which a binder component of the adhesive film is allowed to flow, which is formed on a connection unit to which the one of the surfaces with the concave/convex portions formed thereon is connected.

Moreover, a method for producing a solar battery module in accordance with the present invention is provided with the steps of: arranging a plurality of solar battery cells; with respect to a tab wire having one surface provided with concave/convex portions composed of peak portions and bottom portions which continue in a longitudinal direction, and are alternately formed in a width direction, temporarily contact bonding the one surface onto a rear-surface electrode side of the solar battery cell, with an adhesive film being interposed therebetween, as well as temporarily contact bonding a flat surface on the side opposed to the one surface of the tab wire onto a surface electrode side of the solar battery cell with an adhesive film being interposed therebetween; applying a pressure onto the tab wire with heat being applied thereto to thermally cure the adhesive film so that a main contact bonding process for connecting the tab wire to the respective electrodes of the solar battery cells is carried out, and in this method, in the main contact bonding process, a binder component of the adhesive film is allowed to flow into an opening formed in the connection unit to which the one surface with the concave/convex portions formed thereon of the tab wire is connected.

### Effects of Invention

In accordance with the present invention, a binder component of the adhesive film is allowed to flow along the concave/convex portions into the opening formed in the connection unit. Therefore, since an excessive amount of the binder component can be removed from the connection unit with the tab wire, each solar battery cell makes it possible to ensure conductivity, without the contact between the contact unit and the peak portions of the tab wire being disturbed by the binder resin.

### Brief Description of Drawings

Figure 1 is an exploded perspective view illustrating a solar battery module.
Figure 2 is a cross-sectional view illustrating strings of a solar battery cell.
Figure 3 is a bottom face view illustrating a rear-surface electrode of the solar battery cell to which the present invention is applied.
Figure 4 is a plan view illustrating a state in which a tab wire is main contact-bonded to the rear-surface electrode of the solar battery cell to which the present invention is applied.
Figure 5 is a cross-sectional view illustrating a structure of a conductive adhesive film.
Figure 6 is a view illustrating the conductive adhesive film.
Figure 7 is a view for use in explaining a temporarily contact bonding process of the tab wire.
Figure 8 is a view for use in explaining a main contact bonding process of the tab wire.
Figure 9A shows an example to which the present invention is applied, and Figure 9B is a cross-sectional view showing a comparative example.
Figure 10 is a cross-sectional view illustrating a solar battery cell of a double-faced light receiving type to which the present invention is applied.
Figure 11A and Figure 11B are plan views illustrating a structure in which a flow-out unit is formed on a bus bar electrode 11.
Figure 12 is a side view illustrating a heating press head in which an elastic member is formed on a pressing face for the tab wire.
Figure 13 is a perspective view illustrating a tab wire having concave/convex portions in which peak portions and bottom portions which continue in the longitudinal direction of the surface, and are alternately formed in the width direction.
Figure 14 is a cross-sectional view illustrating the tab wire.
Figure 15 is a cross-sectional view illustrating a solar battery cell to which the tab wire having concave/convex portions in which peak portions and bottom portions which continue in the longitudinal direction of the surface and are alternately formed in the width direction is applied.
Figure 16 is a cross-sectional view illustrating a solar battery cell to which the tab wire having concave/convex portions in which peak portions and bottom portions which continue in the longitudinal direction of the surface and are alternately formed in the width direction, is connected.

### Detailed Description of the Invention

### [Solar Battery Module]

Referring to Figures, the following description will discuss a solar battery module in accordance with the present invention and a method for manufacturing such a solar battery module.

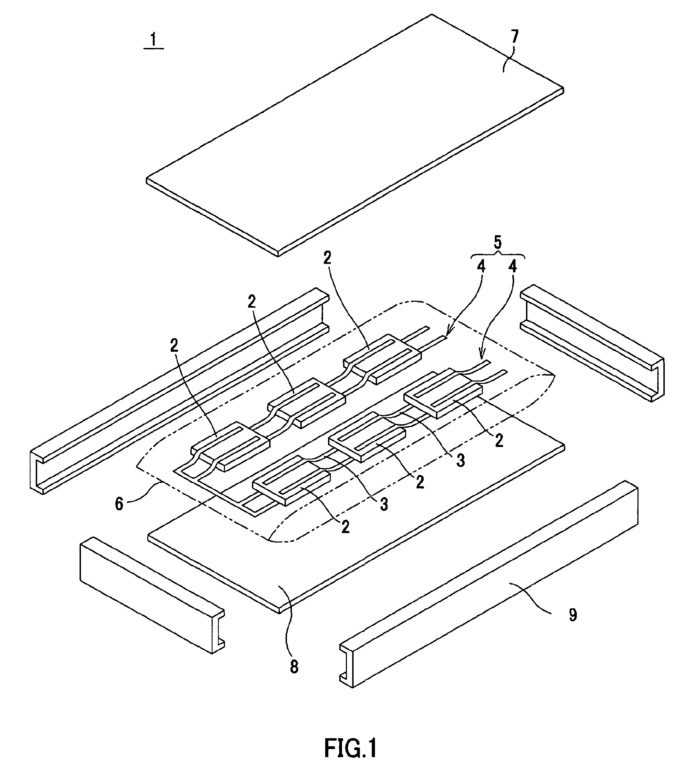

As shown in Fig. 1, a solar battery module 1 to which the present invention is applied has strings 4, each having a plurality of solar battery cells 2 that are connected in series with one another by a tab wire 3 forming interconnectors, and a matrix 5 on which a plurality of these strings 4 are arranged. Moreover, the solar battery module 1 is formed by processes in which the matrix 5 is sandwiched by sheets 6 made of a sealing adhesive agent and laminated by a batch process together with a surface cover 7 formed on a light-receiving surface side and a back sheet 8 formed on a rear surface side, and a metal frame 9 such as aluminum is lastly attached to the peripheral portion of this laminate.

As the sealing adhesive agent, for example, a translucent sealing material such as an ethylene vinyl acetate resin (EVA) or the like is used. Moreover, as the surface cover 7, for example, a translucent material such as glass and a translucent plastic material is used. Furthermore, as the back sheet 8, glass, a laminate formed by sandwiching an aluminum foil with resin films or the like is used.

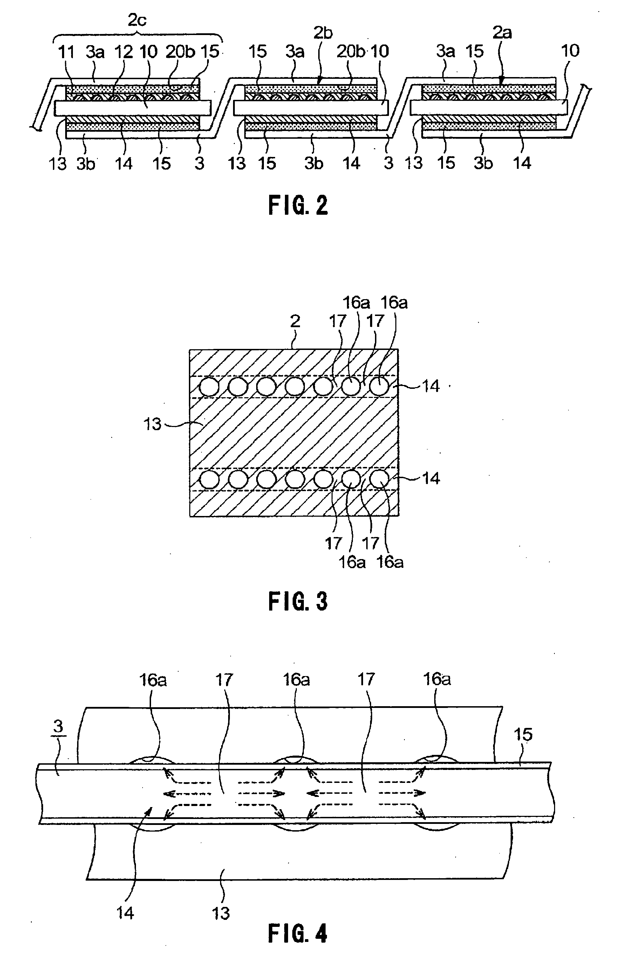

As shown in Fig. 2, each of the solar battery cells 2 of the solar battery module is provided with photoelectric conversion elements 10. As the photoelectric conversion element 10, each of various photoelectric conversion elements 10, such as a crystal silicon-based solar battery module using a single crystal-type silicon photoelectric conversion element or a polycrystal-type photoelectric conversion element, and a thin-film silicon-based solar battery using a photoelectric conversion element in which a cell made of amorphous silicon and a cell made of fine crystal silicon or amorphous silicon germanium are stacked, may be used.

Moreover, the photoelectric conversion element 10 is provided with bus bar electrodes 11 serving as surface electrodes on the light-receiving surface side and finger electrodes 12 serving as collector electrodes formed in a direction virtually orthogonal to the bus bar electrodes 11. Moreover, the photoelectric conversion element 10 is provided with rear-surface electrodes 13 made of aluminum or silver, which are formed on the rear surface side opposed to the light-receiving surface.

In the solar battery cell 2, the bus bar electrodes 11 on the surface and the rear-surface electrodes 13 of the adjacent solar battery cell 2 are electrically connected with each other by the tab wire 3; thus, strings 4 series-connected with one another are formed. The connection between the tab wire 3 and the bus bar electrodes 11 as well as the rear-surface electrodes 13 is made by using a conductive adhesive film 15.

Each bus bar electrode 11 is formed by applying an Ag paste and heating it thereon. The bus bar electrode 11 to be formed on the light-receiving surface of the solar battery cell 2 is formed into, for example, a line shape with a width of 1 mm so as to make an area blocking incident light smaller to suppress shadow loss. The number of the bus bar electrodes 11 is properly determined by taking into consideration the size and resistivity of the solar battery cell 2. After the conductive adhesive film 15 to be described later have been temporarily bonded, the bus bar electrodes 11 are bonded to the flattened rear surface 20b of the tab wire 3.

The finger electrodes 12 are formed over virtually the entire surface of the light-receiving surface of the solar battery cell 2 so as to intersect the bus bar electrodes 11, by using the same method as that of the bus bar electrodes 11. Moreover, each finger electrode 12 has a structure in which lines having, for example, a width of about 100µm, are formed with predetermined intervals, for example, 2 mm.

As shown in Fig. 3, the rear-surface electrodes 13 are prepared as electrodes made of aluminum or silver, which are formed on the rear surface of the solar battery cell 2 by using a screen printing method, a sputtering method, or the like. Each of the rear-surface electrodes 13 is provided with a connection unit 14 to which, after the conductive adhesive film 15 has been temporarily bonded thereto, the surface 20a of the tab wire 3 on which concave/convex portions 21 have been formed is connected. The connection unit 14 is provided with a flow-in unit 16, formed thereon, into which, at the time of a main contact bonding process of the tab wire 3 to be described later, a binder resin of the conductive adhesive film 15 is allowed to flow. The flow-in unit 16 is formed by carrying out a mask treatment, an etching treatment or the like at the time of forming the rear-surface electrodes 13, and, for example, as shown in Fig. 3, it is formed as an opening 16a. That is, the connection unit 14 is constituted by a conduction unit 17 that is made of an Al or Ag portion and provides conduction to the tab wire 3 and the flow-in unit 16 into which, at the time of the main contact bonding process, an excessive binder resin is allowed to flow.

At the connection unit 14 of each rear-surface electrode 13, after the conductive adhesive film 15 and the tab wire 3 have been stacked in this order, a heating and pressing process is carried out on the tab wire 3 so that, as shown by an arrow in Fig. 4, the binder resin of the conductive adhesive film 15 is moved along the concave/convex portions 21, and allowed to flow into the opening 16a such that an excessive binder resin can be removed from the conduction unit 17. Therefore, the solar battery cell 2 makes it possible to ensure conductivity without contacts between the mutual conductive particles in the conduction unit 17 of the connection unit 14, as well as contacts between the conductive particles and the tab wire 3 or the connection unit 14, being disturbed by the binder resin.

The plural openings 16a are formed along the connection unit 14 of each rear-surface electrode 13 with predetermined intervals. Each of the solar battery cells 2 is electrically connected with the adjacent solar battery cell 2 through the tab wire 3 in the conduction unit 17, and is also mechanically connected with the tab wire 3. Moreover, the solar battery cell 2 allows an excessive binder resin to flow into the opening 16a, and is also mechanically connected with the tab wire 3 at the opening 16a. Additionally, the opening 16a may have any shapes, such as a round shape, a rectangular shape, or the like, without limitation.

### [Tab Wire]

In the same manner as in tab wires used in conventional solar battery modules, the tab wire 3 may be formed by using, for example, a ribbon-shaped copper foil having a thickness in a range from 50 to 300µm, and is subjected to a gold plating, a silver plating, a tin plating, a solder plating, or the like, if necessary.

Moreover, in the same manner as in the tab wire 100, the tab wire 3 has a structure in which a plurality of concave/convex portions which continue in the longitudinal direction on its surface and are alternately formed within the width direction. As shown in Fig. 13 the tab wire 3 is formed into an elongated shape, with concave/convex portions 21 being formed on the surface 20a thereof. As shown in Fig. 14, in the concave/convex portions 21, peak portions 21a and bottom portions 21 b, continuously formed in the longitudinal direction of the tab wire 3, are alternately formed in the width direction of the tab wire 3. The concave/convex portions 21 are formed by, for example, press-molding the aforementioned ribbon-shaped copper foil subjected to the plating process.

Moreover, as shown in Fig. 15, the tab wire 3 has its flattened rear-surface 20b side connected with the bus bar electrode 11 of the solar battery cell 2 through the conductive adhesive film 15. With this structure, since the solar battery cell 2 has a structure in which the concave/convex portions 21 are directed in the same direction as that of the light-receiving surface, incident light is scattered by the concave/convex portions 21, and by allowing the scattered light to be reflected by a protective glass surface and again made incident on the light-receiving surface, the light receiving efficiency can be improved.

Moreover, the tab wire 3 has its surface 20a side, with the concave/convex portions 21 formed thereon, connected to the connection unit 14 of the rear-surface electrode 13 of the solar battery cell 2 through the conductive adhesive film 15.

### [Adhesive Film]

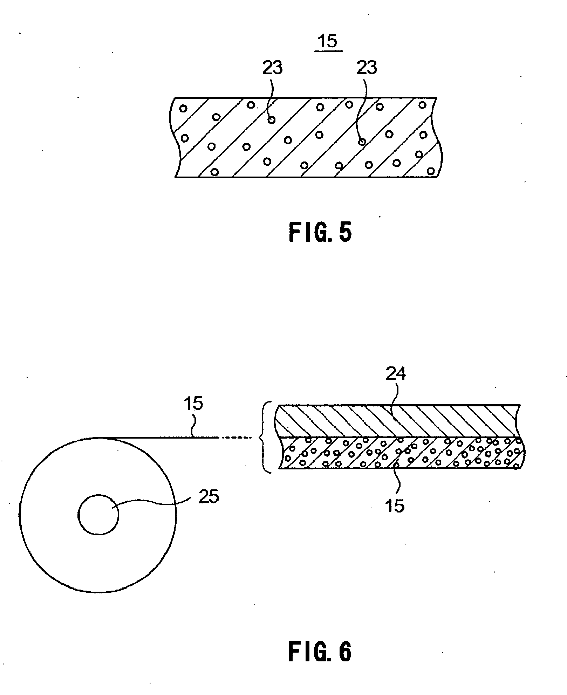

As shown in Fig. 5, the conductive adhesive film 15 is a thermosetting binder resin layer containing conductive particles 23 at high concentration. From the viewpoint of a push-in property, the conductive adhesive film 15 preferably has a lowest melt viscosity in a range from 100 to 100000 P·s in its binder resin. In the conductive adhesive film 15, when the lowest melt viscosity is too low, the resin tends to flow during a main curing process due to a low bonding pressure to easily cause a connection failure and a spew portion onto the cell light-receiving surface and the subsequent reduction in the light-receiving efficiency. In contrast, when the lowest melt viscosity is too high, a failure tends to occur upon bonding the film to sometimes cause an adverse effect on the connection reliability. Additionally, the lowest melt viscosity can be measured through processes in which a predetermined amount of a sample is loaded into a rotary viscometer and measured while being heated at a predetermined temperature-rise rate.

As the conductive particles 23 for use in the conductive adhesive film 15, not particularly limited, for example, metal particles of nickel, gold, copper or the like, resin particles each of which is gold plated, resin particles each of which is gold plated, with its outermost layer being insulation-coated, or the like may be used. Additionally, in the case when flattened flake-shaped metal particles are contained as the conductive particles 23, the number of conductive particles 23 mutually overlapped with one another can be increased so that good conduction reliability can be ensured.

Moreover, the conductive adhesive film 15 preferably has a viscosity in the vicinity of a normal temperature in a range from 10 to 10000 kPa·s, more preferably, in a range from 10 to 5000 kPa·s. By setting the viscosity of the conductive adhesive film 15 in the range from 10 to 10000 kPas·s, it becomes possible to prevent a so-called spew portion even in the case when the conductive adhesive film 15 is prepared as a tape wound into a reel, and also to maintain a predetermined tacking force.

Although the composition of the binder resin layer of the conductive adhesive film 15 is not particularly limited as long as the above-mentioned characteristics are not impaired, the composition preferably contains a film forming resin, a liquid-state epoxy resin, a potential curing agent and a silane coupling agent.

The film forming resin corresponds to a high molecular weight resin having an average molecular weight of 10000 or more, and from the viewpoint of film-forming property, the average molecular weight is preferably set to about 10000 to 80000. As the film forming resin, various resins, such as an epoxy resin, a modified epoxy resin, a urethane resin and a phenoxy resin may be used, and among these, from the viewpoints of a film forming state, connection reliability and the like, the phenoxy resin is more preferably used.

With respect to the liquid-state epoxy resin, not particularly limited, any of commercially available epoxy resins may be used as long as flowability is exerted at a normal temperature. Specific examples of these epoxy resins include: naphthalene type epoxy resins, biphenyl type epoxy resins, phenol-novolak type epoxy resins, bisphenol type epoxy resins, stilbene type epoxy resins, triphenol methane type epoxy resins, phenol-aralkyl type epoxy resins, naphthol type epoxy resins, dicyclopentadiene type epoxy resins, triphenylmethane type epoxy resins, and the like. One of these may be used alone, or two or more kinds of these may be used in combination. Moreover, these may be used in combination with other organic resins such as acrylic resins on demand.

As the potential curing agent, various curing agents, such as a thermosetting-type, UV-curable-type or the like, may be used. The potential curing agent is not reactive in a normal state, but is activated upon application of a trigger of some kind, and starts a reaction. The trigger includes heat, light, pressure application or the like, and can be properly selected depending on use conditions and applied. In the case when a liquid-state epoxy resin is used, a potential curing agent composed of imidazoles, amines, sulfonium salts, onium salts, etc. may be used.

As the silane coupling agent, epoxy-based, amino-based, mercapto-sulfide-based, and ureido-based agents, etc. may be used. Among these, in the present embodiment, epoxy-based silane coupling agents are preferably used.
With this arrangement, the adhesive property on the interface between the organic material and the inorganic material can be improved.

Moreover, as another additive composition, an inorganic filler is preferably contained. By containing the inorganic filler, the flowability of the resin layer at the time of a contact bonding process can be adjusted, and the particle capturing rate can be consequently improved. As the inorganic filler, silica, talc, titanium oxide, calcium carbonate, magnesium oxide, or the like can be used, and the kinds of the inorganic filler are not particularly limited.

Fig. 6 is a drawing that schematically shows an example of a product mode of the conductive adhesive film 15. The conductive adhesive film 15 has a structure in which a binder resin layer is stacked on a peeling substrate 24 and these are molded into a tape state. This tape-state conductive adhesive film is wound around a reel 25 and stacked thereon with the peeling substrate 24 located on the outer circumferential side. As the peeling substrate 24, not particularly limited, PET (Poly Ethylene Terephthalate), OPP (Oriented Polypropylene), PMP (Poly-4-methylpentene-1), PTFE (Polytetrafluoroethylene), etc. may be used. Moreover, the conductive adhesive film 15 may have a structure in which a transparent cover film is formed on the binder resin layer.

At this time, the aforementioned tab wire 3 may be used as the cover film to be bonded onto the binder resin layer. In this manner, by preliminarily stacking the tab wire 3 and the conductive adhesive film 15 as an integral unit, the peeling substrate 24 is separated from the film when actually used, and by bonding the binder resin layer of the conductive adhesive film 15 onto the bus bar electrode 11 or the connection unit 14 of the rear-surface electrode 13 so that the tab wire 3 and the respective electrodes 11 and 13 can be connected with each other.

Additionally, not limited to the reel shape, the conductive adhesive film 15 may have a stripe shape.

In the case when, as shown in Fig. 6, the conductive adhesive film 15 is prepared as a reel product, with the conductive adhesive film 15 being wound around, by setting the viscosity of the conductive adhesive film 15 in a range from 10 to 10000 kPa·s, the conductive adhesive film 15 is prevented from being deformed so as to maintain a predetermined dimension. Moreover, in the case when two or more of the conductive adhesive films 15, each having a stripe shape, are stacked, it is also possible to prevent it from being deformed and consequently to maintain its predetermined dimension, in the same manner as described above.

The above-mentioned conductive adhesive film 15 is prepared by dissolving conductive particles 23, a film-forming resin, a liquid-state epoxy resin, a potential curing agent and a silane coupling agent in a solvent. As the solvent, toluene, ethyl acetate, or the like, or a mixed solvent of these may be used. The resin forming solution, obtained by the dissolving process, is applied onto a peeling sheet, and by evaporating the solvent, a conductive adhesive film 15 is obtained.

### [Production Processes]

The following description will discuss production processes of the solar battery module 1. The production processes of the solar battery module 1 include: a temporarily bonding process in which the conductive adhesive film 15 is temporarily bonded to the bus bar electrode 11 and the connection unit 14 of the rear-surface electrode 13; an arranging process in which the solar battery cells 2 are arranged; a temporarily contact bonding process in which by pressing the tab wire 3 onto the conductive adhesive film 15 white being heated in a low-temperature/low-pressure state, the tab wire 3 is disposed on each of the bus bar electrode 11 and the connection unit 14 of the rear-surface electrode 13; and a main contact bonding process in which by carrying out a heating and pressing process on the tab wire 3, the conductive adhesive film 15 is thermally cured so that the tab wire 3 and each of the bus bar electrode 11 and the connection unit 14 of the rear-surface electrode 13 are connected with each other.

First, an uncured conductive adhesive film 15 is temporarily bonded onto the bus bar electrode 11 and the connection unit 14 of the rear-surface electrode 13 of each of the solar battery cells 2. The temporarily bonding process of the conductive adhesive film 15 is carried out, for example, by transporting the conductive adhesive film 15 wound around into a reel shape to a predetermined position on the surface and rear-surface sides of each of the solar battery cells 2, where it is pressed by a temporarily bonding head.

The temporarily bonding head carries out a heating process for a predetermined period of time (for example, 1 to 5 seconds) at a temperature (for example, from 40 to 60°C) in such a level that although flowability is caused in the conductive bonding film 15, no main cured state is caused therein; thus, the conductive bonding film 15 is temporarily bonded to each of the solar battery cells 2. The solar battery cells 2, each having the conductive adhesive film 15 temporarily bonded thereto, are arranged in the order of being series-connected.

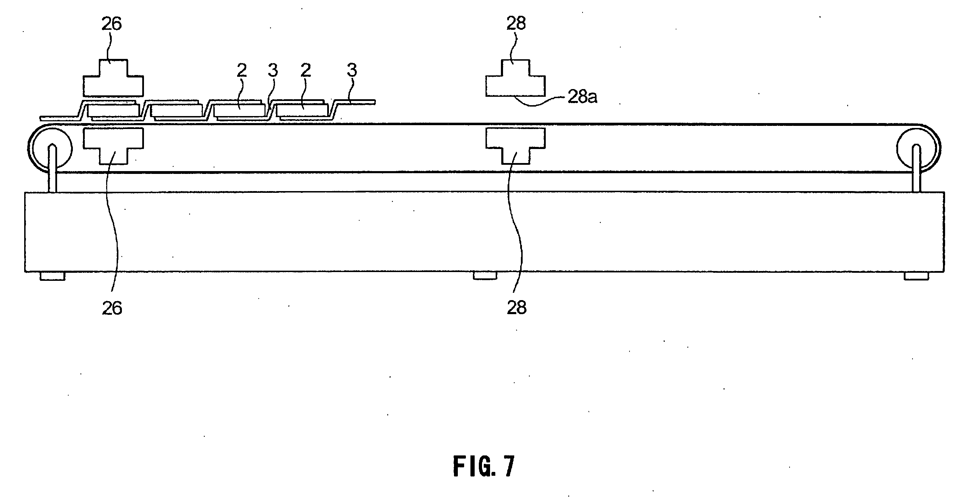

Next, a tab wire 3 is temporarily contact bonded to the conductive adhesive film 15, with respect to each of the solar battery cells 2 that are arranged as predetermined positions that are opposed to paired upper and lower temporarily contact bonding heads 26. At this time, as shown in Fig. 2 and Fig. 7, onto a bus bar electrode 11 formed on the surface of one proceeding solar battery cell 2a, one end 3a of the tab wire 3 is temporarily contact bonded with an uncured conductive adhesive film 15 interpolated therebetween, and onto the connection unit 14 of the rear-surface electrode 13 of succeeding another solar battery cell 2b, the other end 3b of the tab wire 3 is temporarily contact bonded with an uncured conductive adhesive film 15 interpolated therebetween. In the same manner, onto the bus bar electrode 11 formed on the surface of the corresponding the other solar battery cell 2b, and onto the connection unit 14 of the rear-surface electrode 13 of a solar battery cell 2c following the solar battery cell 2b, the one end 3a and the other end 3b of the tab wire 3 are temporarily contact bonded, with uncured conductive adhesive film 15 interpolated therebetween. Thus, the adjacent solar battery cells 2 are mutually series-connected to one after another with the tab wire 3.

At this time, as shown in Fig. 15, the rear-surface 20b of the tab wire 3, flatly formed, is temporarily contact bonded onto the bus bar electrode 11 on one end 3a side, while the surface 20a thereof with concave/convex portions 21 formed thereon is temporarily contact bonded onto the connection unit 14 of the rear-surface electrode 13 on the other end 3b side, as described earlier.

These temporarily contact bonding processes are carried out by the temporarily contact bonding head 26. The temporarily contact bonding head 26 is heated to a temperature in such a level as not to proceed a curing reaction of the conductive adhesive film 15, and presses the tab wire 3. Therefore, the conductive adhesive film 15 allows the binder resin to exert flowability to cause an adhesive strength so that the tab wire 3 is temporarily secured onto the bus bar electrode 11 and the connection unit 14 of the rear-surface electrode 13.

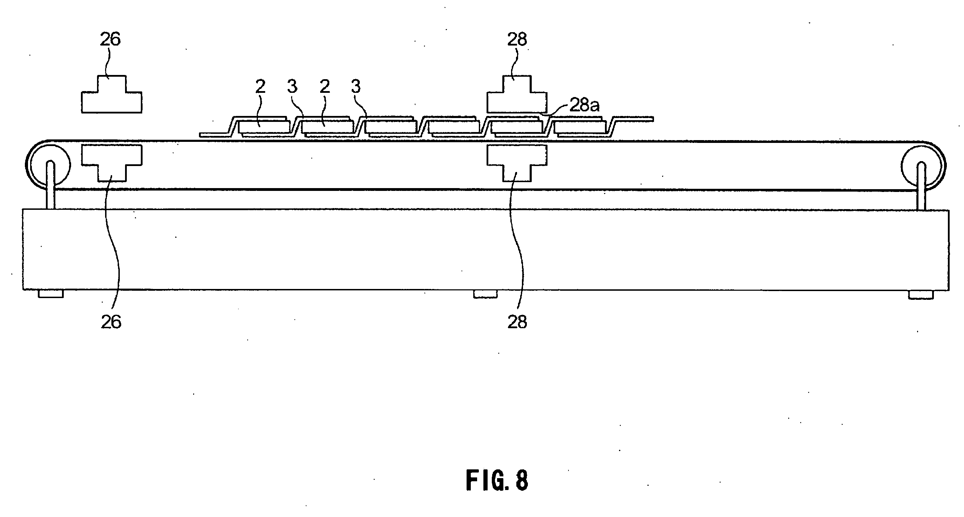

Next, as shown in Fig. 8, the plural solar battery cells 2, each having the tab wire 3 temporarily secured thereon, are transported and supported right below a heating and pressing head 28, and thereafter, the tab wire 3 is mainly contact bonded onto each of the electrodes 11 and 13 of the solar battery cell 2 by the heating and pressing head 28 so that the conductive adhesive film 15 is thus cured.

At this time, with respect to the plural solar battery cells 2, the tab wire 3 of a preceding solar battery cell 2a is pressed at a predetermined pressure by the paired heating and pressing heads 28 formed on the upper and lower sides when they are raised and lowered in synchronism with each other. The heating and pressing heads 28 are heated to a predetermined temperature at which the conductive adhesive film 15 is cured. Therefore, the conductive adhesive film 15 has its binder resin thermally cured so that the tab wire 3 and the bus bar electrode 11 or the connection unit 14 of the rear-surface electrode 13 are connected with each other electrically as well as mechanically.

As shown in Fig. 4, upon connecting the surface 20a of the tab wire 3 and the connection unit 14 of the rear-surface electrode 13 of the solar battery cell 2, the binder resin having flowability in the solar battery cell 2 is allowed to flow through the bottom portions 21 b that continue in the longitudinal direction of the tab wire 3 and consequently to flow into the opening 16a formed in the connection unit 14 of the rear-surface electrode 13. Therefore, the solar battery cell 2 is allowed to remove an excessive binder resin in the conduction unit 17 of the connection unit 14 so that conductive particles in the conduction unit 17 are mutually made in contact with one another, and the conductive particles and the peak portions 21 a of the tab wire 3, as well as the conduction unit 17, are made in contact with each other, without being interfered with the binder resin. With this arrangement, each solar battery cell 2 makes it possible to ensure and improve conductivity to the tab wire 3 in the connection unit 14.

In this case, the opening 16a may have a diameter that is larger than the width of the tab wire 3 and the conductive adhesive film 15. With this arrangement, the opening 16a positively allows an excessive binder resin to flow therein so as to be removed from the conduction unit 17, and deviations in the bonding positions between the tab wire 3 and the conductive adhesive film 15 can also be prevented.

Moreover, the area ratio of the opening 16a relative to the conduction unit 17 of the rear-surface electrode 13 is preferably set in a range of 2 : 1 to 1 : 2 (opening 16a : conduction unit 17 = 2 : 1 to 1 : 2). When the area of the opening 16a exceeds the above range of the area ratio, the moving loss of electrons to be collected in the conduction unit 17 becomes greater. In contrast, when the area of the opening 16a is less than half of the area of the conduction unit 17, the opening 16a might fail to allow an excessive binder resin to sufficiently flow therein.

After the main contact bonding process of the tab wire 3 onto the preceding solar battery cell 2a has been carried out by the heating and pressing heads 28, the paired heating and pressing heads 28 are separated from the tab wire 3, and the succeeding solar battery cell 2b is transported right below the paired heating and pressing heads 28. In this manner, the solar battery cells 2 are transported right below the paired heating and pressing heads 28 one by one, and the tab wire 3 is successively bonded to the bus bar electrode 11 and the connection unit 14 of the rear-surface electrode 13, while being successively series-connected with the adjacent solar battery cell 2.

Additionally, in the present embodiment, since the connection unit 14 and the tab wire 3 are connected with each other by using the conductive adhesive film 15, either Al or Ag can be used as the rear-surface electrode 13 of the solar battery cell 2, and by using a rear-surface Al collector electrode as the rear-surface electrode 13, it becomes possible to eliminate the need for installing an Ag electrode for use in solder connection, which is conventionally required; thus, this method shortens the production processes of solar battery cells, and is advantageous in production techniques.

Moreover, in the present embodiment, the connection between the conduction unit 17 of the connection unit 14 and the tab wire 3 is carried out by using the conductive adhesive film 15; however, an insulating adhesive film containing no conductive particles in its binder resin may be used. In this case, the peak portions 2 1 a of the concave/convex portions 21 of the tab wire 3 are directly made in contact with the conduction unit 17 of the connection unit 14 so that conduction is prepared. In this case also, by forming a flow-in unit 16 in the connection unit 14, an excessive binder resin of the insulating adhesive film is allowed to flow therein in the main contact bonding process of the tab wire 3 so that the peak portions 21 a and the conduction unit 17 can be connected without being disturbed by the binder resin.

### [Example 1]

The following description will discuss an example in which to the connection unit 14 on which the conduction unit 17 and the opening 16a are formed, the surface 20a of the tab wire 3 with the concave/convex portions 21 formed thereon is connected, with a conductive adhesive film 15 (trade name: SP100 Series, made by Sony Chemical & Information Device Corporation) interpolated therebetween.

In example 1 also, the conduction unit 17 was formed on the connection unit of a glass substrate by using Ag paste wiring, and a plurality of openings having a diameter of 2 mm were formed with intervals of 2 mm. On this connection unit, the conductive adhesive film 15 and the tab wire 3 were successively stacked, and the tab wire 3 was heated and pressed to be connected with each other. The heating and pressing conditions were at 180°C, for 15 seconds at 1 MPa.

In comparative example 1, only the conduction unit 17 was formed on the connection unit of a glass substrate by using Ag paste wiring, with no openings formed therein. Then, in the same manner as in example 1, the same conductive adhesive film 15 and the tab wire 3 as those of example 1 were successively stacked on the connection unit, and the tab wire 3 was heated and pressed to be connected with each other. The heating and pressing conditions were at 180°C, for 15 seconds at 1 MPa.

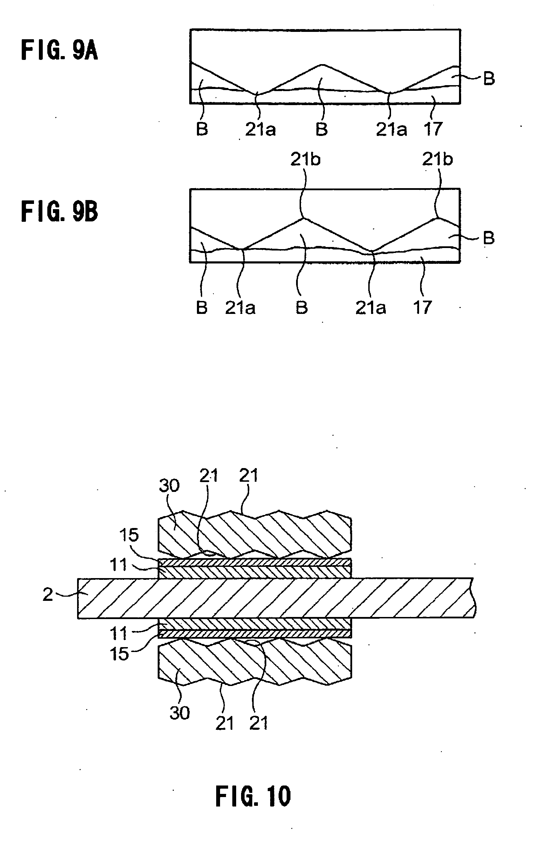

When the connection cross sectional face of each of example 1 and comparative example 1 was observed, connection to the conduction unit 17 was conformed in all the peak portions 2 1 a at 10 positions in example 1, as shown in Fig. 9A. This is because by forming the openings, an excessive portion of the binder resin B having flowability was allowed to flow into the openings by the heating and pressing processes, with the result that the excessive binder resin B was removed from the gap between the peak portions 21a and the conduction unit 17.

On the other hand, as shown in Fig. 9B, in comparative example 1, connection with the conduction unit 17 was made only in three peak portions 21a at 10 positions, and the other peak portions 21a were separated from the conduction unit 17. Moreover, in comparative example 1, even at the connected portions, the connection was made in such a degree that only the apex of each peak portion 21a is made in contact with the conduction unit 17. This is because even when the binder resin B became flowable due to the heating, the flowing direction was limited since the bottom portions 21b were continuously formed along the longitudinal direction of the tab wire 3, with the result that the removal of the resin from the gap between the peak portions 21a of the tab wire 3 and the conduction unit 17 became insufficient even by the pressing process. Consequently, in comparative example 1, the excessive binder resin B still remained between the tab wire 3 and the conduction unit 17 to cause a failure in connection.

Next, with respect to the cell in which the surface 20a of the tab wire 3 with the concave/convex portions 21 formed thereon is connected to the connection unit 14 on which the conduction unit 17 and the opening 16a are formed, with a conductive adhesive film 15 interpolated therebetween, an output characteristic thereof was examined.

In example 2, by using a solar battery cell the entire surface of which was covered with an Al electrode serving as a rear-surface electrode, the connection unit with the tab wire 3 was formed on the Al electrode, with a plurality of openings having a diameter of 4 mm being formed on the connection unit with intervals of 4 mm, together with the conduction unit. Additionally, in this solar battery cell, no bus bar electrode was present on the light-receiving surface side, and finger electrodes and the tab wire were connected with each other. The same conductive adhesive film 15 and the tab wire 3 as those of example 1 were successively stacked on the connection unit, and the tab wire 3 was heated and pressed to be connected with each other. The heating and pressing conditions were at 180°C, for 15 seconds at 1 MPa.

In example 3, the connection was carried out in the same conditions as those of example 2 except that in place of the conductive adhesive film 15 of example 2, an insulating adhesive film from which conductive particles were excluded was used. As a result, in the same manner as in example 1, connection to the conduction unit 17 was conformed in all the peak portions 21a at 10 positions.

In comparative example 2, the connection was carried out in the same conditions as those of example 2 except that no openings were formed.

In these example 2, example 3 and comparative example 2, as the initial output characteristic, a value was found from an expression {FF value immediately after the connection of the tab wire 3 (value obtained by dividing the maximum output of the solar battery by [release voltage × short-circuit current]) / FF value before the connection of the tab wire 3} × 100(%). As a result, 97.1% was obtained in example 2 and 97.0% was obtained in example 3, while 96.2% was obtained in comparative example 2, thereby indicating that the connection was stabilized by installing the openings. In this case, the measuring method of the FF value was based upon JIS C8913 (output measuring method for crystal-based solar battery cell module).

Next, the respective samples of example 2, example 3 and comparative example 2 were laminated with reinforced glass, EVA and back-sheet, and the respective solar battery modules thus finished were subjected to temperature-cycle tests. The temperature cycle tests were carried out for 1000 cycles, each cycle having a process at -40°C for 30 minutes ↔ a process at 100°C for 30 minutes. Then, the value of (FF value before the test/FF value after the test) × 100(%) was found. As a result, 98.5% was obtained in example 2 and 97.8% was obtained in example 3, while 96% was obtained in comparative example 2, thereby indicating that high connection reliability against environmental changes can be obtained by installing the openings. In this case, the measuring method of the FF value was based upon JIS C8913 (output measuring method for crystal-based solar battery cell module).

### [Other Structures]

Additionally, the solar battery cell 2 may have a structure in which Si forming the photoelectric conversion element 10 is externally exposed through the openings 16a. With this arrangement, in the solar battery cell 2, the binder resin of the conductive adhesive film 15 is made in contact with Si on the surface of the photoelectric conversion element 10 through the openings 16a of the rear-surface electrode 13. Since the surface of the solar battery cell made of the silicon substrate and the binder resin of the conductive adhesive film 15 are firmly bonded to each other, the conductive adhesive film 15 secures conduction through the conduction unit 17 (A1 portion) in the connection between the tab wire 3 and the rear-surface electrode 13, and also ensures the connection strength between the tab wire 3 and the connection unit 14 of the rear-surface electrode 13 by the Si portion exposed through the openings 16a.

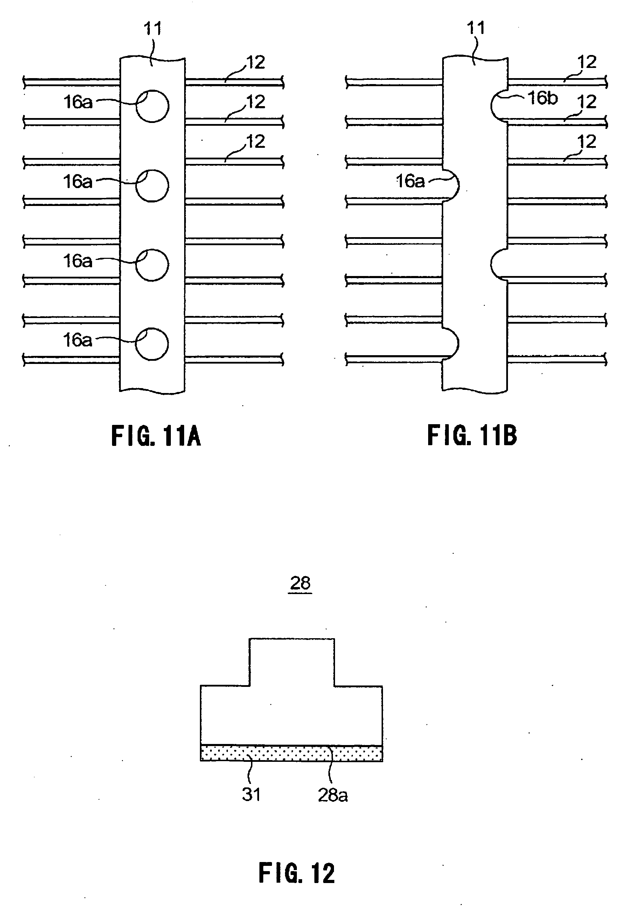

Moreover, in the case of a solar battery cell 2 of a double-faced light receiving type, as shown in Fig. 10, a tab wire 30 having concave/convex portions 21 formed on the two surfaces thereof may be used, and a flow-in unit 16 that allows an excessive binder resin to flow therein may be formed on each of bus bar electrodes 11 formed on the two light-receiving surfaces. The flow-in unit 16 is formed by a batch process, upon print-forming each of the bus bar electrodes 11. Moreover, as shown in Fig. 11A, the flow-in unit 16 may be formed as the opening 16a. In the case when it is formed as the opening 16a, its diameter is made smaller than the width of the bus bar electrode 11. Moreover, the flow-in unit 16 may be formed as a cut-out portion 16b formed by cutting out one portion of the bus bar electrode 11, as shown in Fig. 11B.

With respect to the opening 16a and the cut-out portion 16b to be formed on the bus bar electrode 11, a plurality of them are formed on the bus bar electrode 11 with predetermined intervals. Moreover, even in the case when, upon the main contact bonding process of the tab wire 3, a binder resin flows in through the bottom portions 21b of the concave/convex portions 21, the opening units 16a and the cut-out portions 16b make it possible to remove an excessive binder resin from the conduction unit 17.

Additionally, with respect to the heating and pressing head 28 for use in heating and pressing the tab wire 3 in the main contact bonding process of the tab wire 3, as shown in Fig. 12, an elastic member 31 may be formed on the pressing face 28a thereof. By installing an elastic member 31 made of silicone rubber having a high thermal conductivity in the heating and pressing head 28, the heating and pressing head 28 is allowed to follow the concave/convex portions 21 of the tab wire 3 and have an increased contact area between the pressing face 26a and the tab wire 3 so as to be more tightly adhered to each other, with the concave/convex portions on the surface of the tab wire being maintained, so that heat and pressure can be positively transferred to the tab wire 3 uniformly.

### Reference Signs List

- 1: solar battery module
- 2: solar battery cell
- 3: tab wire
- 4: strings
- 5: matrix
- 10: photoelectric conversion element
- 11: bus bar electrode
- 12: finger electrode
- 13: rear-surface electrode
- 14: connection unit
- 15: conductive adhesive film
- 16: flow-in unit
- 16a: opening
- 16b: cut-out portion
- 17: conduction unit
- 20a: surface
- 20b: rear-surface
- 21: concave/convex portions
- 21a: peak portions
- 21b: bottom portions
- 23: conductive particles
- 26: temporarily contact bonding head
- 28: heating and pressing head
- 30: tab wire
- 31: elastic member

## Claims

1. A solar battery module comprising:
a plurality of solar battery cells, each having two surfaces on which electrodes are formed;
a tab wire that is provided with concave/convex portions composed of peak portions and bottom portions which continue in a longitudinal direction, and are alternately formed in a width direction on one of the surfaces, the tab wire being used for connecting the plural solar battery cells in series with one after another; and
an adhesive film that is interposed between the electrodes of the solar battery cells and the tab wire so as to connect the solar battery cells and the tab wire with each other,
wherein each of the solar battery cells has a flow-in unit in which a binder component of the adhesive film is allowed to flow, the flow-in unit being formed on a connection unit to which the one of the surfaces with the concave/convex portions formed thereon is connected.

2. The solar battery module according to claim 1, wherein the tab wire has a flat surface on the side opposed to the one surface with the concave/convex portions formed thereon that is connected to surface electrodes of the solar battery cell, with the one surface being connected to rear-surface electrodes of the solar battery cell.

3. The solar battery module according to claim 1, wherein on a surface on the side opposed to the one surface with the concave/convex portions formed thereon, the tab wire also has concave/convex portions that are composed of peak portions and bottom portions which continue in a longitudinal direction, and are alternately formed in a width direction.

4. The solar battery module according to any one of claims 1 to 3, wherein the rear-surface electrodes of the solar battery cell are formed by using Al.

5. The solar battery module according to claim 4, wherein the solar battery cell is a crystal silicon-based solar battery cell, with Si being externally exposed through the flow-in unit.

6. The solar battery module according to any one of claims 2 to 5, wherein the flow-in unit is an opening formed in the connection unit with the tab on the rear-surface electrodes.

7. The solar battery module according to any one of claims 2 to 5, wherein the flow-in unit is a cut-out portion formed in the connection unit with the tab on the rear-surface electrodes.

8. The solar battery module according to any one of claims 1 to 7, wherein the connection unit has a conduction unit conductive to the tab wire, which has an area larger than that of the flow-in unit.

9. The solar battery module according to any one of claims 1 to 8, wherein the adhesive film contains conductive particles.

10. The solar battery module according to any one of claims 1 to 8, wherein the adhesive film is an insulating adhesive film containing no conductive particles.

11. A method for producing a solar battery module comprising the steps of:
arranging a plurality of solar battery cells;
with respect to a tab wire having one surface provided with concave/convex portions composed of peak portions and bottom portions which continue in a longitudinal direction, and are alternately formed in a width direction, temporarily contact bonding the one surface onto a rear-surface electrode side of the solar battery cell, with an adhesive film being interposed therebetween, as well as temporarily contact bonding a flat surface on the side opposed to the one surface of the tab wire onto a surface electrode side of the solar battery cell with an adhesive film being interposed therebetween;
applying a pressure onto the tab wire with heat being applied thereto to thermally cure the adhesive film so that a main contact bonding process for connecting the tab wire to the respective electrodes of the solar battery cells is carried out,
wherein in the main contact bonding process, a binder component of the adhesive film is allowed to flow into the opening formed in the connection unit to which the one surface with the concave/convex portions formed thereon of the tab wire is connected.

12. The method for producing a solar battery module according to claim 11, wherein in the main contact bonding process, the tab wire is heated and pressed by using a head having a pressing surface for the tab wire on which an elastic member is formed.
